# EUROPEAN PATENT SPECIFICATION

(11) **EP 4 207 290 B1**
(45) Date of publication and mention of the grant of the patent: **07.10.2026**
(21) Application number: 22217361.9
(22) Date of filing: 30.12.2022
(51) Int. Cl.: H10F 39/00, H10F 39/18

(54) **IMAGE SENSOR AND ELECTRONIC APPARATUS INCLUDING THE IMAGE SENSOR**
BILDSENSOR UND ELEKTRONISCHE VORRICHTUNG MIT DEM BILDSENSOR
CAPTEUR D'IMAGE ET APPAREIL ÉLECTRONIQUE COMPRENANT LE CAPTEUR D'IMAGE

(30) Priority: 04.01.2022 KR 20220000932; 19.10.2022 KR 20220135235; 05.12.2022 KR 20220168132
(43) Date of publication of application: 05.07.2023
(73) Proprietor: Samsung Electronics Co., Ltd., Suwon-si 16677 (KR)
(72) Inventor: Roh, Younggeun, 16678 Suwon-si, Gyeonggi-do (KR); Kim, Hyochul, 16678 Suwon-shi, Gyeonggi-do (KR)
(74) Representative: Grünecker Patent- und Rechtsanwälte PartG mbB

(56) References cited:
- US-A1- 2021 313 359
- AMR M SHALTOUT ET AL: "Ultrathin and Multicolor Optical Cavities with Embedded Metasurfaces", ARXIV.ORG, CORNELL UNIVERSITY LIBRARY, 201 OLIN LIBRARY CORNELL UNIVERSITY ITHACA, NY 14853, 15 November 2017 (2017-11-15), XP081404274, DOI: 10.1038/S41467-018-05034-6
- FELIX GILDAS ET AL: "Review of nanostructure color filters", JOURNAL OF NANOPHOTONICS, vol. 13, no. 02, 17 June 2019 (2019-06-17), US, pages 1, XP055608813, ISSN: 1934-2608, DOI: 10.1117/1.JNP.13.020901

## Description

### Description of the Related Art

Image sensors sense the color of incident light commonly by using color filters. In general, color filters are absorption-type filters that selectively transmit light only in a specific wavelength band and absorb light in the other wavelength bands. The transmission spectrum of an absorption-type filter may be determined by the thickness of the absorption-type filter. As the thickness of a filter decreases, the filter is likely to transmit light in an undesired wavelength band. Thus, there is a limit to reducing the thickness of filters.

In addition, ultra-high-resolution, ultra-small, and high-sensitivity image sensors having hundreds of millions of pixels or more have recently been developed. However, as the pixel size of image sensors decreases, the thickness of absorption-type filters increases relative to the pixel size. For this reason, light passing through color filters enters adjacent other pixels, so that crosstalk may easily occur.
US 2021/313359 A1 discloses a light detecting device including a filter array including filters two-dimensionally arrayed and an image sensor including light detection elements. Each of first and second filters included in the filters includes a first reflective layer, a second reflective layer, and an intermediate layer therebetween, and has a resonance structure having resonant modes whose orders are different from each other. A refractive index and/or a thickness of the intermediate layer in the first and second filters is different depending on the filter. A transmission spectrum of each of the first and second filters has local maximum value of transmittance at each of wavelengths included in a wavelength region, and the wavelengths correspond to the resonant modes, respectively. The image sensor is disposed at a position where the image senor receives passing light that passes through the filter array, to detect components in the wavelengths included in the passing light.
Amr M Shaltout et al.: "Ultrathin and Multicolor Optical Cavities with Embedded Metasurfaces", ARXIV.ORG, CORNELL UNIVERSITY LIBRARY, 201 OLIN LIBRARY CORNELL UNIVERSITY ITHACA, NY 14853, 15 November 2017 (2017-11-15) discloses multicolour optical cavities with embedded metasurfaces.
It is the object of the present invention to provide an improved image sensor capable of reducing crosstalk while also reducing the thickness of color filters.
This object is solved by the subject matter of the independent claims.
Embodiments are defined by the dependent claims.

One or more embodiments provide an image sensor capable of reducing crosstalk by reducing the thickness of color filters, and an electronic apparatus including the image sensor.

The invention is claimed in the independent claims. Preferred embodiments are specified in the dependent claims.

Further, one or more embodiments provide an image sensor capable of reducing crosstalk by additionally absorbing or reflecting light in an undesired wavelength band, and an electronic apparatus including the image sensor.

Additional aspects will be set forth in part in the description which follows and, in part, will be apparent from the description, or may be learned by practice of the presented embodiments of the disclosure.

According to an aspect of the disclosure, an image sensor includes: a sensor substrate including a plurality of first pixels and a plurality of second pixels; and a color filter array including a plurality of first color filters respectively corresponding to the plurality of first pixels and a plurality of second color filters respectively corresponding to the plurality of second pixels, wherein each of the plurality of first color filters and the plurality of second color filters includes: an absorption-type filter layer including a polymer-based pigment; and a resonator including a first reflective film provided on a lower surface of the absorption-type filter layer and a second reflective film provided on an upper surface of the absorption-type filter layer, to allow light to resonate in the absorption-type filter layer, and wherein the lower surface and the upper surface of the absorption-type filter layer may oppose each other.

The absorption-type filter layer of each the plurality of first color filters may include a first pigment, which transmits light in a first wavelength band and absorbs light in other wavelength bands, and the absorption-type filter layer of each of the plurality of second color filters may include a second pigment, which transmits light in a second wavelength band different from the first wavelength band and absorbs light in other wavelength bands.

For example, the resonator may have a Q-factor of about 1.5 to about 20.

For example, the resonator may have a Q-factor of about 2 to about 10.

For example, the resonator may have a Q-factor of about 2 to about 5.

The resonator may have a Fabry-Perot resonant structure in which the absorption-type filter layer is disposed inside the resonator.

For example, an arithmetic sum of a reflectance of the first reflective film and a reflectance of the second reflective film may be about 50 % to about 150 %.

The reflectance of the first reflective film and the reflectance of the second reflective film may be set such that a transmission spectrum of each of the plurality of first color filters and the plurality of second color filters may have a full width at half maximum within a range of about 50 nm to about 250 nm.

Each of the first reflective film and the second reflective film may have a one-dimensional periodic structure in which periodic structures are arranged in one direction, or two-dimensional periodic structure in which the periodic structures are arranged in two directions.

Each of the first reflective film and the second reflective film may include a distributed Bragg reflector.

For example, each of the first reflective film and the second reflective film may include at least one metal or metalloid material selected from polysilicon (poly-Si), gold (Au), copper (Cu), aluminum (Al), silver (Ag), tungsten (W), and titanium (Ti).

For example, each of the first reflective film and the second reflective film may have a thickness of about 1 nm to about 30 nm.

For example, the first reflective film and the second reflective film may include at least one dielectric material selected from poly-Si, TiN, SiO2, TiO2, HfO2, Ta2O5, SiC, and SiN.

For example, each of the first reflective film and the second reflective film may have a thickness of about 30 nm to about 600 nm.

The absorption-type filter layer of each of the plurality of first color filters may have a thickness equal to a thickness of the absorption-type filter layer of each of the plurality of second color filters.

In the plurality of first color filters and the plurality of second color filters, the first reflective films may cause different phase delays, or the second reflective films may cause different phase delays.

The absorption-type filter layer of each of the plurality of first color filters may have a first thickness, and the absorption-type filter layer of each of the plurality of second color filters may have a second thickness different from the first thickness.

The first thickness of the absorption-type filter layer of each of the plurality of first color filters may be set such that a center wavelength of a transmission wavelength band of each of the plurality of first color filters may be equal to a resonant wavelength of the resonator of each of the plurality of first color filters, and the second thickness of the absorption-type filter layer of each of the plurality of second color filters may be set such that a center wavelength of a transmission wavelength band of each of the plurality of second color filters may be equal to a resonant wavelength of the resonator of each of the plurality of second color filters.

For example, the absorption-type filter layer may have a thickness of about 100 nm to about 1000 nm.

According to another aspect of the disclosure, an electronic apparatus includes: an image sensor configured to convert an optical image into an electrical signal; a processor configured to control the image sensor, wherein the image sensor includes: a sensor substrate including a plurality of first pixels and a plurality of second pixels; and a color filter array including a plurality of first color filters respectively corresponding to the plurality of first pixels and a plurality of second color filters respectively corresponding to the plurality of second pixels, wherein each of the plurality of first color filters and the plurality of second color filters includes: an absorption-type filter layer including a polymer-based pigment; and a resonator including a first reflective film and a second reflective film provided on two opposing surfaces of the absorption-type filter layer, respectively, to allow light to resonate in the absorption-type filter layer.

According to another aspect of the disclosure, an image sensor may include: a color filter layer configured to pass a transmission wavelength band and absorb other wavelength bands except for the transmission wavelength band via a polymer material included in the color filter layer; and a resonator including a first reflective film provided on a light incident surface of the color filter layer, and a second reflective film provided on a light exiting surface of the color filter layer which opposes the light incident surface, wherein the resonator may have a quality factor of 1.5 to 20 and causes light to resonate within the color filter layer provided between the first reflective film and the second reflective film.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a block diagram illustrating an image sensor according to an embodiment;
FIGS. 2A, 2B, and 2C are views illustrating various example pixel arrangements of a pixel array of the image sensor;
FIGS. 3A and 3B are views schematically illustrating different cross-sections of the pixel array of the image sensor according to an embodiment;
FIGS. 4A, 4B, 4C, and 4D are perspective views schematically illustrating structures of color filters according to various embodiments;
FIG. 5 is a graph illustrating a comparison between a transmission spectrum of a color filter provided according to an embodiment and a transmission spectrum of a color filter provided according to a comparative example;
FIGS. 6A and 6B are views schematically illustrating different cross-sections of a pixel array of the image sensor according to another embodiment;
FIGS. 7A and 7B are cross-sectional views schematically illustrating structures of a color filter according to another embodiment;
FIGS. 8A and 8B are views schematically illustrating different cross-sections of a pixel array of the image sensor according to another embodiment;
FIG. 9 is a cross-sectional view schematically illustrating a structure of a pixel array of the image sensor according to another embodiment;
FIG. 10 is a graph illustrating a comparison between a transmission spectrum of a color filter provided according to the embodiment shown in FIG. 9 and a transmission spectrum of a color filter provided according to a comparative example;
FIG. 11 is a cross-sectional view schematically illustrating a structure of a color filter according to another embodiment;
FIG. 12 is a cross-sectional view schematically illustrating a structure of a color filter according to another embodiment;
FIG. 13 is a block diagram schematically illustrating an electronic apparatus including the image sensor according to embodiments;
FIG. 14 is a block diagram schematically illustrating a camera module shown in FIG. 13; and
FIGS. 15 to 24 are views illustrating various examples of an electronic apparatus including the image sensor according to embodiments.

### DETAILED DESCRIPTION

Example embodiments are described in greater detail below with reference to the accompanying drawings.

In the following description, like drawing reference numerals are used for like elements, even in different drawings. The matters defined in the description, such as detailed construction and elements, are provided to assist in a comprehensive understanding of the example embodiments. However, it is apparent that the example embodiments can be practiced without those specifically defined matters. Also, well-known functions or constructions are not described in detail since they would obscure the description with unnecessary detail.

As used herein, the term "and/or" includes any and all combinations of one or more of the associated listed items. Expressions such as "at least one of," when preceding a list of elements, modify the entire list of elements and do not modify the individual elements of the list.

Hereinafter, an image sensor and an electronic apparatus including the image sensor will be described with reference to the accompanying drawings. Embodiments described herein are for illustrative purposes only, and various modifications may be made therein. In the drawings, like reference numerals refer to like elements, and the sizes of elements may be exaggerated for clarity of illustration.

In the following description, when an element is referred to as being "above" or "on" another element, it may be directly on an upper, lower, left, or right side of the other element while making contact with the other element or may be above an upper, lower, left, or right side of the other element without making contact with the other element.

Although the terms "first" and "second" are used to describe various elements, these terms are only used to distinguish one element from another element. These terms do not limit elements to having different materials or structures.

The terms of a singular form may include plural forms unless otherwise mentioned. It will be further understood that the terms "comprises" and/or "comprising" used herein specify the presence of stated features or elements, but do not preclude the presence or addition of one or more other features or elements.

In the disclosure, terms such as "unit" or "module" may be used to denote a unit that has one or more functions or operations and is implemented with hardware, software, or a combination of hardware and software.

An element referred to with the definite article or a demonstrative determiner may be construed as the element or the elements even though it has a singular form.

Operations of a method may be performed in appropriate order unless explicitly described in terms of order or described to the contrary. In addition, examples or exemplary terms (for example, "such as" and "etc.") are used for the purpose of description and are not intended to limit the scope of the inventive concept unless defined by the claims.

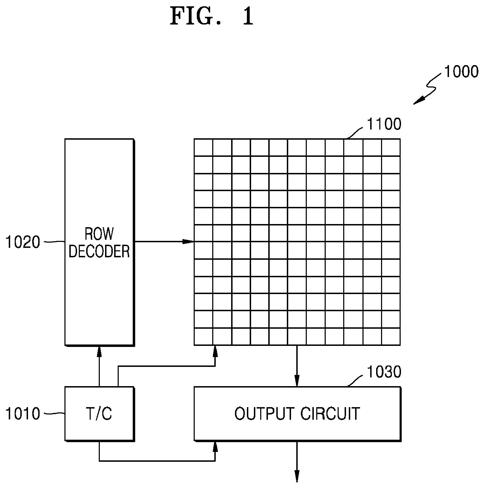

FIG. 1 is a block diagram schematically illustrating an image sensor 1000 according to an embodiment. Referring to FIG. 1, the image sensor 1000 may include a pixel array 1100, a timing controller 1010, a row decoder 1020, and an output circuit 1030. The image sensor 1000 may be a charge coupled device (CCD) image sensor or a complementary metal oxide semiconductor (CMOS) image sensor.

The pixel array 1100 includes pixels, which are two-dimensionally arranged in rows and columns. The row decoder 1020 selects one row of the pixel array 1100 in response to a row address signal output from the timing controller 1010. Light sensing signals from a plurality of pixels arranged in the selected row are output through the output circuit 1030 in units of columns. To this end, the output circuit 1030 may include a column decoder and an analog-to-digital converter (ADC). For example, the output circuit 1030 may include a plurality of ADCs, which are arranged between the column decoder and the pixel array 1100 respectively for the columns, or may include one ADC arranged at an output terminal of the column decoder. The timing controller 1010, the row decoder 1020, and the output circuit 1030 may be provided as a single chip or as separate chips. A processor for processing image signals output through the output circuit 1030 may be included in a single chip together with the timing controller 1010, the row decoder 1020, and the output circuit 1030.

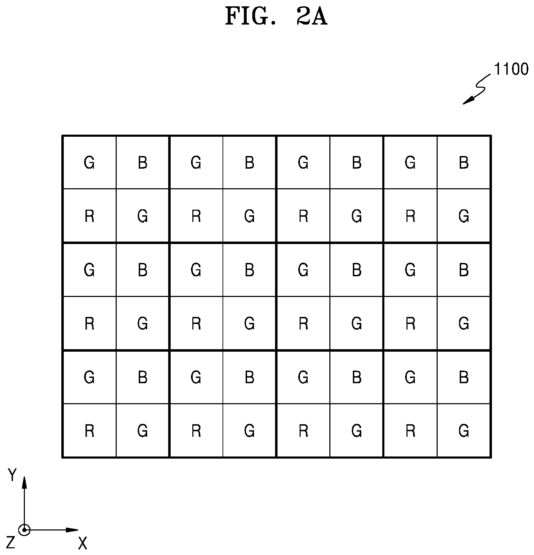

The pixel array 1100 may include pixels for sensing light having different wavelengths. The plurality of pixels may be arranged in various manners. For example, FIGS. 2A to 2C illustrate various pixel arrangements of the pixel array 1100 of the image sensor 1000.

First, FIG. 2A illustrates a Bayer pattern, which is generally employed in the image sensor 1000. In the following description, for ease of illustration, a Z direction is referred to as a first direction, and X and Y directions perpendicular to the Z direction are referred to as second and third directions, respectively. Referring to FIG. 2A, one unit pattern includes four quadrant regions, and first to fourth quadrant regions may respectively be a blue pixel B, a green pixel G, a red pixel R, and a green pixel G. The unit pattern is two-dimensionally repeated in the second direction (X direction) and the third direction (Y direction). In other words, in each unit pattern of a 2x2 array type, two green pixels G are arranged in a diagonal direction, and one blue pixel B and one red pixel R are arranged in the other diagonal direction. In the pixel arrangement, a first row, in which a plurality of green pixels G and a plurality of blue pixels B are alternately arranged in the second direction, and a second row, in which a plurality of red pixels R and a plurality of green pixels G are alternately arranged in the second direction, are repeatedly arranged in the third direction.

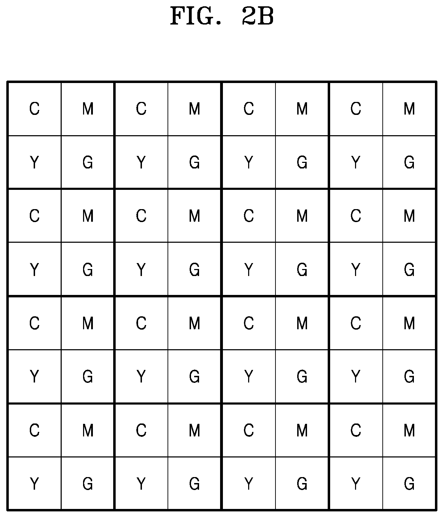

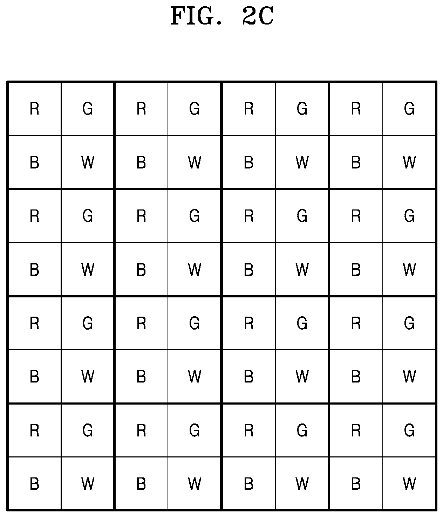

The pixel array 1100 may have various pixel arrangements other than the Bayer pattern. For example, as shown in FIG. 2B, a CYGM arrangement may also be possible, in which one unit pattern includes a magenta pixel M, a cyan pixel C, a yellow pixel Y, and a green pixel G. In addition, as shown in FIG. 2C, an RGBW arrangement may also be possible, in which one unit pattern includes a green pixel G, a red pixel R, a blue pixel B, and a white pixel W. In addition, unit patterns of a 3x2 array type may also be possible. In addition, the plurality of pixels of the pixel array 1100 may be arranged in various other manners according to the color characteristics of the image sensor 1000.

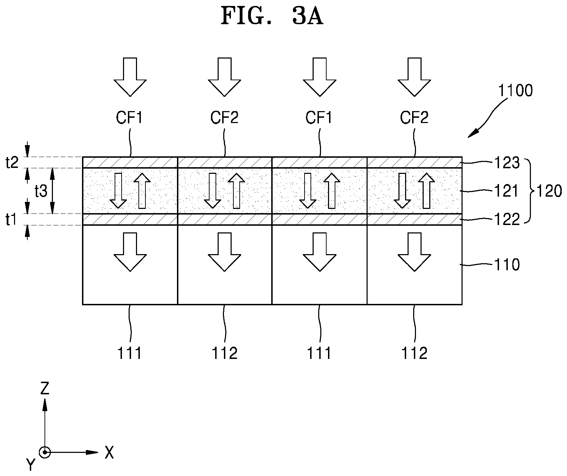

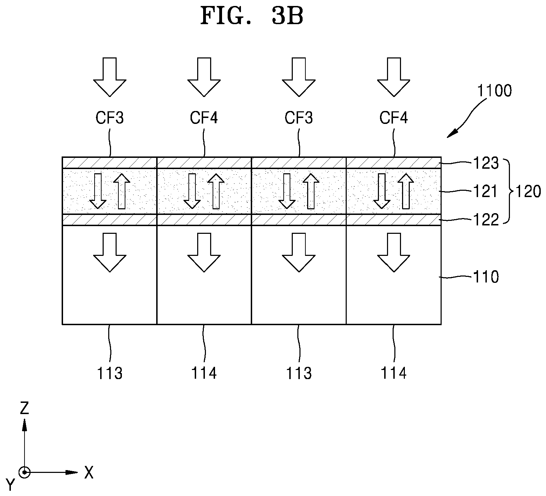

FIGS. 3A and 3B are views schematically illustrating different cross-sections of the pixel array 1100 of the image sensor 1000 according to an embodiment. Referring to FIGS. 3A and 3B, the pixel array 1100 of the image sensor 1000 may include a sensor substrate 110 including a plurality of pixels 111, 112, 113, and 114 configured to sense light and a color filter array 120 including a plurality of color filters CF1, CF2, CF3, and CF4 configured to transmit light in a certain wavelength band and absorb or reflect light in the other wavelength bands. The color filter array 120 may be disposed on an upper surface of the sensor substrate 110. The plurality of color filters CF1, CF2, CF3, and CF4 may respectively correspond to the plurality of pixels 111, 112, 113, and 114, and each of the plurality of color filters CF1, CF2, CF3, and CF4 may face a corresponding one of the plurality of pixels 111, 112, 113, and 114.

The sensor substrate 110 may include a first pixel 111, a second pixel 112, a third pixel 113, and a fourth pixel 114, which are configured to convert light into electrical signals. For example, each of the first pixel 111, the second pixel 112, the third pixel 113, and the fourth pixel 114 may include a photodiode configured to absorb and detect light. As shown in FIG. 3A, the first pixel 111 and the second pixel 112 may be alternately arranged in the second direction (that is, the X direction). As shown in FIG. 3B, in a cross section taken at a different position in the third direction (that is, the Y direction) with respect to the first and second pixels 111 and 112, the third and fourth pixels 113 and 114 may be alternately arranged in the second direction. A pixel isolation layer may be further formed along boundaries between the plurality of pixels to separate the plurality of pixels.

The color filter array 120 may include a first color filter CF1 disposed on the first pixel 111, a second color filter CF2 disposed on the second pixel 112, a third color filter CF3 disposed on the third pixel 113, and a fourth color filter CF4 disposed on the fourth pixel 114. For example, when a Bayer pattern is employed, the first color filter CF1 and the fourth color filter CF4 may be green color filters configured to mainly transmit green light, the second color filter CF2 may be a blue color filter configured to mainly transmit blue light, and the third color filter CF3 may be a red color filter configured to mainly transmit red light. The pixel arrangements of the pixel array 1100 described with reference to FIGS. 2A to 2C may be implemented by the arrangement of the plurality of color filters CF1, CF2, CF3, and CF4 of the color filter array 120. Although FIGS. 3A and 3B illustrate an example in which the pixel array 1100 of the image sensor 1000 has a Bayer pattern, pixel arrangements other than the Bayer pattern may be employed.

According to an embodiment, each of the first to fourth color filters CF1, CF2, CF3, and CF4 may include an absorption-type filter layer 121, and a resonator configured to allow light to resonate within the absorption-type filter layer 121. The absorption-type filter layers 121 of the first to fourth color filters CF1, CF2, CF3, and CF4 may include different polymer-based pigments. For example, the absorption-type filter layers 121 of the first color filter CF1 and the fourth color filter CF4 may include a first pigment, which mainly transmits light in a first wavelength band (that is, green light) and absorbs light in other wavelength bands (that is, blue and red light). In addition, the absorption-type filter layer 121 of the second color filter CF2 may include a second pigment, which mainly transmits light in a second wavelength band (that is, blue light) different from the first wavelength band and absorbs light in other wavelength bands (that is, green and red light), and the absorption-type filter layer 121 of the third color filter CF3 may include a third pigment, which mainly transmits light in a third wavelength band (that is, red light) different from the first and second wavelength bands and absorbs light in other wavelength bands (that is, blue and green light).

Each of the resonators may have, for example, a Fabry-Perot resonant structure in which the absorption-type filter layer 121 is disposed inside the resonator. To this end, as shown in FIGS. 3A and 3B, the resonator may include a first reflective film 122 disposed on a lower surface of the absorption-type filter layer 121 and a second reflective film 123 disclosed on an upper surface of the absorption-type filter layer 121. In other words, the absorption-type filter layer 121 may be disclosed between the first reflective film 122 and the second reflective film 123 of the resonator which face each other. The first reflective film 122 and the second reflective film 123 may half mirrors configured to reflect a portion of light and transmit the other portion of the light. In this case, a portion of light incident on the first reflective film 122 may pass through the absorption-type filter layer 121 and reach the second reflective film 123. In addition, a portion of light incident on the second reflective film 123 may pass through the second reflective film 123 and reach the sensor substrate 110, and the other portion of the light may be reflected by the second reflective film 123 such that the other portion of the light may pass through the absorption-type filter layer 121 again and reach the first reflective film 122.

In this manner, light passes through the absorption-type filter layer 121 a plurality of times while resonating in the first direction (Z direction) within the absorption-type filter layer 121. This increases the length of a path along which light travels in the absorption-type filter layer 121, and thus, substantially the same effect as that of increasing the thickness of the absorption-type filter layer 121 may be obtained. Therefore, although the thickness t3 of the absorption-type filter layer 121 is decreased in the first direction (Z direction), a sufficiently high absorption ratio may be obtained in a wavelength band other than a transmission wavelength band, and a desired transmission spectrum may be obtained. For example, the thickness t3 of the absorption-type filter layer 121 may range from about 100 nm to about 1000 nm, from about 100 nm to about 500 nm, or from about 200 nm to about 400 nm.

In addition, although the path-increasing effect increases as a quality factor (Q-factor) of the resonator increases, an excessively high Q-factor decreases the full width at half maximum of a transmission spectrum of each of the first to fourth color filters CF1, CF2, CF3, and CF4, and causes each of the first to fourth color filters CF1, CF2, CF3, and CF4 to transmit light only in an excessively narrow wavelength band. Therefore, the resonator does not need to strictly satisfy resonance conditions for a transmission band, but merely needs to satisfy resonance conditions for light to pass through the absorption-type filter layer 121 repeatedly about two to three times on average. For example, the Q-factor of the resonator may range from about 1.5 to about 20, from about 2 to about 10, or from about 2 to about 5. In addition, the Q-factors of the first to fourth color filters CF1, CF2, CF3, and CF4 may be equal to each other or different from each other. Here, the Q-factor of each of the first to fourth color filters CF1, CF2, CF3, and CF4 may be defined as λ/Δλ, where λ refers to the central wavelength of the transmission spectrum of each of the first to fourth color filters CF1, CF2, CF3, and CF4, and Δλ refers to the full width at half maximum of the transmission spectrum of each of the first to fourth color filters CF1, CF2, CF3, and CF4. For example, the full width at half maximum of the transmission spectrum of each of the first to fourth color filters CF1, CF2, CF3, and CF4 may be within the range of about 50 nm to about 250 nm

The Q-factor of the resonator is determined by the thickness t3 and light absorptivity of the absorption-type filter layer 121, the reflectance of the first reflective film 122, and the reflectance of the second reflective film 123. Because the thickness t3 and light absorptivity of the absorption-type filter layer 121 are fixed conditions, the Q-factor of the resonator may be mainly controlled by the reflectance of the first reflective film 122 and the reflectance of the second reflective film 123. To satisfy the Q-factor value described above, the reflectance of the first reflective film 122 and the reflectance of the second reflective film 123 do not need to be high. For example, the arithmetic sum of the reflectance of the first reflective film 122 and the reflectance of the second reflective film 123 may be about 50 % to about 150 %. The reflectance of the first reflective film 122 and the reflectance of the second reflective film 123 may be equal to each other or different from each other. For example, both the reflectance of the first reflective film 122 and the reflectance of the second reflective film 123 may be about 50 %. The reflectance of the first reflective film 122 may be about 20 % to about 30 %, and the reflectance of the second reflective film 123 may be about 80 % to about 90 %. or the reflectance of the first reflective film 122 may be about 80 % to about 90 %, and the reflectance of the second reflective film 123 may be about 20 % to about 30 %. The reflectance of the first reflective film 122 and the reflectance of the second reflective film 123 may be determined such that the resonator has a Q-factor of about 1.5 to about 20, or the transmission spectrum of the first to fourth color filters CF1, CF2, CF3, and CF4 may have a full width at half maximum of about 50 nm to about 250 nm.

The reflectance of the first reflective film 122 may be determined by the thickness t1 and the material of the first reflective film 122, and the reflectance of the second reflective film 123 may be determined by the thickness t2 and the material of the second reflective film 123.

The first reflective film 122 and the second reflective film 123 may each have a flat mirror structure including a single material. For example, the first reflective film 122 and the second reflective film 123 may include at least one material selected from polysilicon (poly-Si), gold (Au), copper (Cu), aluminum (Al), silver (Ag), or tungsten (W), titanium (Ti), TiN, SiO2, TiO2, HfO2, Ta2O5, SiC, and SiN. In addition, the thickness t1 of the first reflective film 122 may be about 1 nm to about 600 nm, and the thickness t2 of the second reflective film 123 may be about 1 nm to about 600 nm. For example, when the first reflective film 122 or the second reflective film 123 includes at least one metal or metalloid selected from polysilicon (poly-Si), gold (Au), copper (Cu), aluminum (Al), silver (Ag), tungsten (W), and titanium (Ti), the thickness t1 of the first reflective film 122 or the thickness t2 of the second reflective film 123 may be about 1 nm to about 30 nm. In addition, when the first reflective film 122 or the second reflective film 123 includes at least one dielectric material selected from TiN, SiO2, TiO2, HfO2, Ta2O5, SiC, and SiN, the thickness t1 of the first reflective film 122 or the thickness t2 of the second reflective film 123 may be about 30 nm to about 600 nm.

The resonant wavelengths of the resonators of the first to fourth color filters CF1, CF2, CF3, and CF4 may be within the transmission bands of the first to fourth color filters CF1, CF2, CF3, and CF4, respectively. In other words, the resonant wavelength of the resonator of the first color filter CF1 may be within the transmission band of the first color filter CF1, the resonant wavelength of the resonator of the second color filter CF2 may be within the transmission band of the second color filter CF2, the resonant wavelength of the resonator of the third color filter CF3 may be within the transmission band of the third color filter CF3, and the resonant wavelength of the resonator of the fourth color filter CF4 may be within the transmission band of the fourth color filter CF4. For example, the resonant wavelengths of the resonators of the first and fourth color filters CF1 and CF4 may be within the wavelength band of green light, the resonant wavelength of the resonator of the second color filter CF2 may be within the wavelength band of blue light, and the resonant wavelength of the resonator of the third color filter CF3 may be within the wavelength band of red light.

The resonant wavelength of each of the resonators may be determined by the thickness t3 and refractive index of the absorption-type filter layer 121, a phase delay caused by the first reflective film 122, and a phase delay caused by the second reflective film 123. When the thicknesses t3 of the absorption-type filter layers 121 of the first to fourth color filters CF1, CF2, CF3, and CF4 are equal to each other, the resonant wavelength of the resonator of each of the first to fourth color filters CF1, CF2, CF3, and CF4 may be adjusted based on the phase delay caused by the first reflective film 122 and the phase delay caused by the second reflective film 123. The phase delay caused by the first reflective film 122 and the phase delay caused by the second reflective film 123 may be determined by the materials and surface structures of the first reflective film 122 and the second reflective film 123. Therefore, the materials and surface structures of the first reflective film 122 and the second reflective film 123 of each of the first to fourth color filters CF1, CF2, CF3, and CF4 may be selected such that the resonant wavelengths of the resonators of the first to fourth color filters CF1, CF2, CF3, and CF4 may respectively be within the transmission bands of the first to fourth color filters CF1, CF2, CF3, and CF4. In other words, the first reflective films 122 or the second reflective films 123 of the first to fourth color filters CF1, CF2, CF3, and CF4 may cause different phase delays.

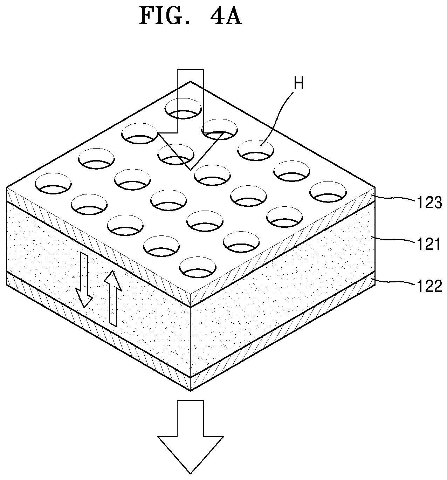

Although FIGS. 3A and 3B illustrate that the first and second reflective films 122 and 123 have a simple flat mirror structure having a flat surface, the surface structures of the first and second reflective films 122 and 123 are not limited thereto. For example, FIGS. 4A to 4D are perspective views schematically illustrating structures of color filters according to various embodiments.

Referring to FIG. 4A, a first reflective film 122 and a second reflective film 123 may include a plurality of recesses H that are periodically arranged. For example, the recesses H may be arranged in a regular two-dimensional array form. The recesses H in the first reflective film 122 may be arranged symmetrically to the recesses H in the second reflective film 123. A pitch of the plurality of recesses H may range from about 0.1 µm to about 10 µm. A diameter of each of the plurality of recesses H may range from about 0.2 to about 0.8 of the pitch. The insides of the recesses H may be filled with a material different from the materials of the first reflective film 122 and the second reflective film 123. The material filled in the recesses H may include a dielectric material having a relatively low refractive index. For example, the recesses H may be filled with a dielectric material having a refractive index of 2.5 or less. For example, the dielectric material filled in the recesses H may include at least one dielectric material selected from SiO2, SiN, Al2O3, and HfO2. For example, the recesses H may be filled with a material (e.g., polymer) having a low thermal conductivity (e.g., 0.1 W/mK or lower). Alternatively, the insides of the recesses H may be empty or may be filled with air. The recesses H may penetrate the first reflective film 122 and the second reflective film 123, or the recesses H may be formed by partially etching the surfaces of the first reflective film 122 and the second reflective film 123 such that the recesses H may not penetrate the first reflective film 122 and the second reflective film 123. Although FIG. 4A illustrates that each of the recesses H has a circular shape, embodiments are not limited thereto. Each of the recesses H may have a circular shape, an oval shape, or various polygonal shapes.

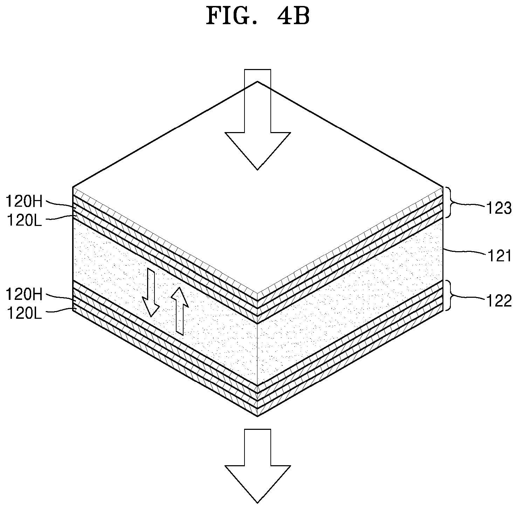

Referring to FIG. 4B, a first reflective film 122 and a second reflective film 123 may each have a multilayer structure in which at least one first dielectric layer 120L having a first refractive index and at least one second dielectric layer 120H having a second refractive index different from the first refractive index are alternately stacked. For example, each of the first reflective film 122 and the second reflective film 123 may be a distributed Bragg reflector (DBR). A thickness of each of the at least one first dielectric layer 120L and the at least one second dielectric layer 120H may range from about 15 nm to about 150 nm.

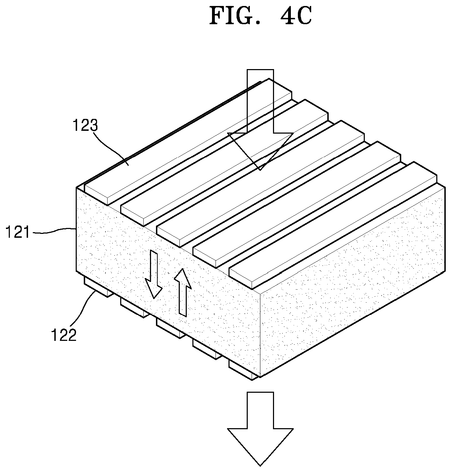

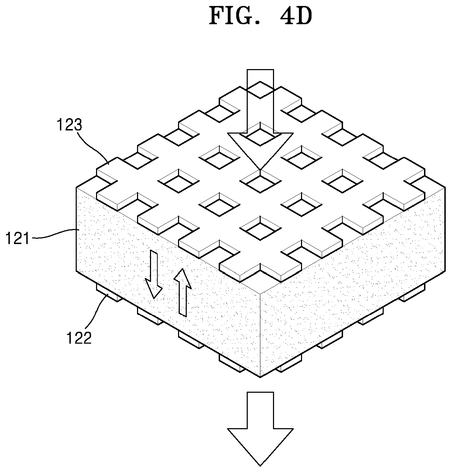

Referring to FIG. 4C, a first reflective film 122 and a second reflective film 123 may each have a periodic one dimensional grating structure including a plurality of gratings (e.g., bar-shaped gratings) which are one-dimensionally arranged. In addition, referring to FIG. 4D, a first reflective film 122 and a second reflective film 123 may have a periodic two-dimensional grating structure including a plurality of gratings which are two-dimensionally arranged in a grid form. A pitch of the plurality of gratings may range from about 0.1 µm to about 10 µm. A width of each of the plurality of gratings may range from about 0.1 to about 0.9 of the pitch.

As shown in FIGS. 4A to 4D, the first and second reflective films 122 and 123 may have a one-dimensional periodic structure in which periodic structures are arranged in one direction (e.g., an x-axis direction, a y-axis direction, or a z-axis direction), or two-dimensional periodic structure in which periodic structures are arranged in two directions (e.g., an x-axis direction and a y-axis direction). Factors such as the reflectance of each of the first and second reflective films 122 and 123, phase delays caused by the first and second reflective films 122 and 123, and the resonant wavelengths of the resonators may be determined by adjusting, for example, the period of the periodic structure, the shape of the periodic structure, or the thickness of the periodic structure.

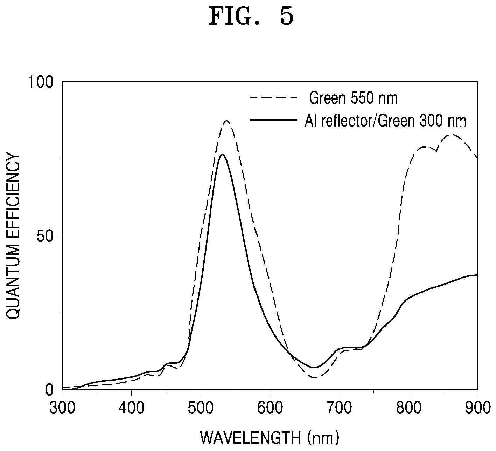

FIG. 5 is a graph illustrating a comparison between a transmission spectrum of a color filter provided according to an embodiment and a transmission spectrum of a color filter provided according to a comparative example. The color filter of the comparative example is a general absorption-type green filter having a thickness of about 550 nm. The color filter of the embodiment includes an absorption-type filter layer 121 including an absorption-type green filter having a thickness of about 300 nm. and a first reflective film 122 and a second reflective film 123 each including a thin aluminum (Al) film having a thickness of about 10 nm or less. In the graph shown in FIG. 5, a dashed curve refers to a transmission spectrum of the color filter of the comparative example, and a solid curve refers to a transmission spectrum of the color filter of the embodiment. Referring to FIG. 5, the transmittance of the color filter of the comparative example is relatively high not only in a green wavelength band but also in an infrared wavelength band equal to or greater than about 800 nm. However, the transmittance of the color filter of the embodiment is relatively low in the infrared wavelength band equal to or greater than about 800 nm or more. In the graph of FIG. 5, the transmittance of the color filter may be expressed as a quantum efficiency, which indicates a ratio of the number of photons that are collected by a photodetector to the number of photons incident on the color filter.

Therefore, according to the embodiment, relatively high wavelength selection performance may be obtained while substantially reducing the thickness of color filters. For example, the absorption-type filter layer 121 may have a thickness of about 100 nm to about 1000 nm, about 100 nm to about 500 nm, or about 200 nm to about 400 nm. In addition, owing to a small color filter thickness, the occurrence of crosstalk in the image sensor 1000 may be reduced, and the pixel size of the image sensor 1000 may be further reduced. Therefore, the image sensor 1000 may easily be manufactured as an ultra-high-resolution image sensor.

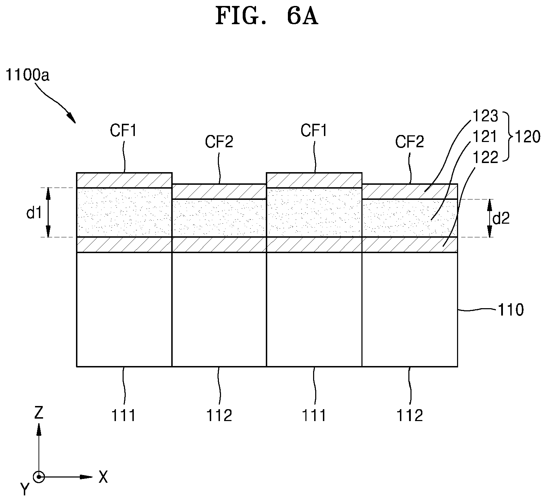

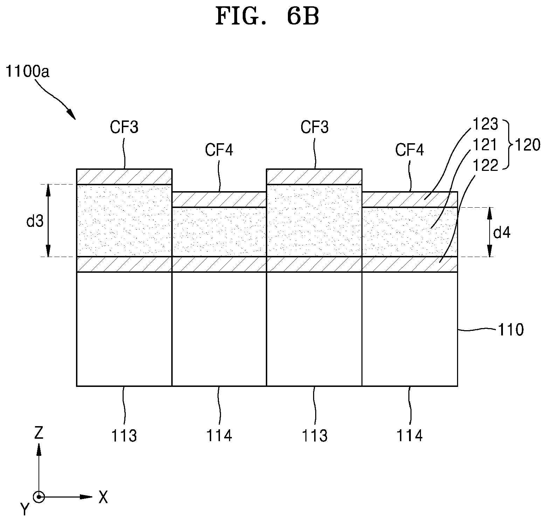

FIGS. 6A and 6B are views schematically illustrating different cross-sections of a pixel array 1100a of the image sensor 1000 according to another embodiment. FIG. 3A and 3B illustrate that the absorption-type filter layers 121 of the first to fourth color filters CF1, CF2, CF3, and CF4 have the same thickness. However, embodiments are not limited thereto. Referring to FIGS. 6A and 6B, in the pixel array 1100a of the current embodiment, absorption-type filter layers 121 of first to fourth color filters CF1, CF2, CF3, and CF4 may have different thicknesses. For example, the absorption-type filter layer 121 of the first color filter CF1 may have a first thickness d1, the absorption-type filter layer 121 of the second color filter CF2 may have a second thickness d2, the absorption-type filter layer 121 of the third color filter CF3 may have a third thickness d3, and the absorption-type filter layer 121 of the fourth color filter CF4 may have a fourth thickness d4. Thicknesses of the first to fourth color filters CF1, CF2, CF3, and CF4 may be proportional to transmission wavelengths of the first to fourth color filters CF1, CF2, CF3, and CF4. For example, when the first and fourth color filters CF1 and CF4 are green color filters, the second color filter CF2 is a blue color filter, and the third color filter CF3 is a red color filter, the third thickness d3 may be the largest, the second thickness d2 may be the smallest, and the first thickness d1 and the fourth thickness d4 may be less than the third thickness d3 but greater than the second thickness d2 and may be equal to equal to each other.

When the thicknesses of the absorption-type filter layers 121 of the first to fourth color filters CF1, CF2, CF3, and CF4 are different from each other, the thicknesses of the absorption-type filter layers 121 may be determined by the resonant wavelengths of resonators of the first to fourth color filters CF1, CF2, CF3, and CF4. In other words, the thicknesses of the absorption-type filter layers 121 may be determined such that the center wavelengths of the transmission wavelength bands of the first to fourth color filters CF1, CF2, CF3, and CF4 may respectively be equal to the resonant wavelengths of the resonators. For example, in the first and fourth color filters CF1 and CF4, the first thickness d1 and the fourth thickness d4 of the absorption-type filter layers 121 may be determined such that the center wavelength of a green wavelength band may be equal to the resonant wavelength of the resonators. In the second color filter CF2, the second thickness d2 of the absorption-type filter layer 121 may be determined such that the center wavelength of a blue wavelength band may be equal to the resonant wavelength of the resonator. Furthermore, in the third color filter CF3, the third thickness d3 of the absorption-type filter layer 121 may be determined such that the central wavelength of a red wavelength band may be equal to the resonant wavelength of the resonator. In this case, first and second reflective films 122 and 123 of the first to fourth color filters CF1, CF2, CF3, and CF4 may have the same thickness, material, and surface structure.

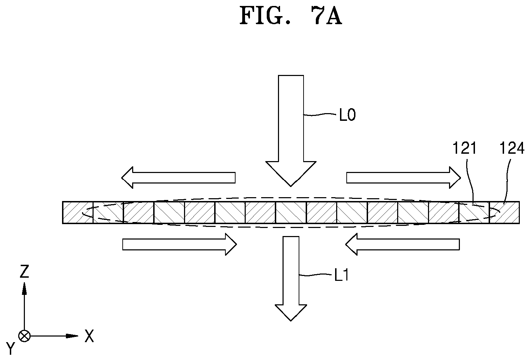

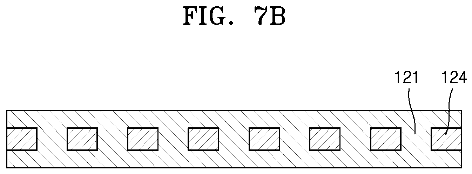

In the embodiments described above, light resonates in the first direction (Z direction). That is, in the embodiments described above, the resonators have a vertical resonant structure. However, embodiments are not limited thereto, and resonators having a horizontal resonant structure may be used. For example, FIGS. 7A and 7B are cross-sectional views schematically illustrating structures of a color filter according to another embodiment.

Referring to FIG. 7A, the color filter may include a resonator having a plurality of nanostructures 124 that are arranged one-dimensionally or two-dimensionally on a plane parallel to a surface of a sensor substrate and an absorption-type filter layer 121 provided between the nanostructures 124. Each of the nanostructures 124 may have a size less than a transmission wavelength of the color filter. For example, the cross-sectional width or diameter of each of the nanostructures 124 may be less than about 400 nm, about 300 nm, or about 200 nm. Each of the nanostructures 124 may include a material having a refractive index greater than that of the absorption-type filter layer 121. For example, each of the nanostructures 124 may include at least one material selected from TiO2, HfO2, Si, and SiN. For example, the resonator including the nanostructures 124 may have a one-dimensional or two-dimensional periodic structure such as a photonic crystal structure, or a chirped structure having a gradually varying period. In this case, light may resonate in a second direction (X direction) or a third direction (Y direction) perpendicular to a first direction (Z direction). That is, light may resonate in a horizontal direction which is a direction in which the surface plane of the color filter extends. In this respect, the resonator is a horizontal resonator in which resonance occurs in a horizontal direction.

Incident light L0 resonates in the second direction (X direction) or the third direction (Y direction) by the resonator, and light L1 output after resonance may be incident on the sensor substrate 110 shown in FIG. 3A. The absorption-type filter layer 121 may be provided to fill a space between the nanostructures 124 of the resonator. Therefore, during resonance, light in a wavelength band other than a transmission band may be absorbed by the absorption-type filter layer 121 while repeatedly passing through the absorption-type filter layer 121.

In addition, referring to FIG. 7B, the absorption-type filter layer 121 may fill the space between the nanostructures 124 of the resonator and completely cover lower and upper surfaces of the nanostructures 124 of the resonator. Therefore, the nanostructures 124 of the resonator may be embedded or buried in the absorption-type filter layer 121.

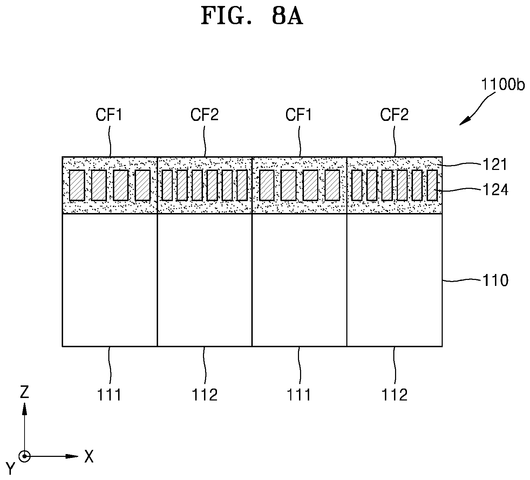

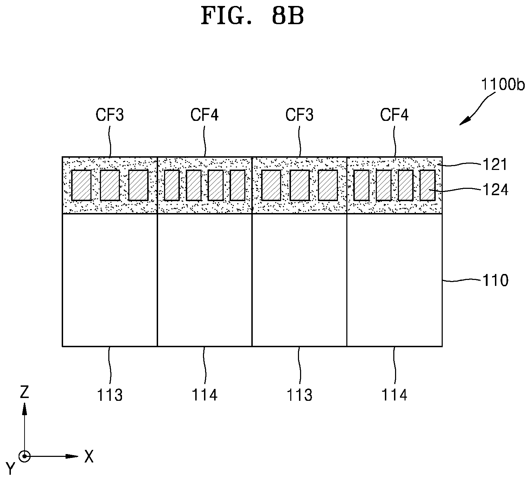

FIGS. 8A and 8B are schematic cross-sectional views illustrating different cross-sections of a pixel array 1100b of the image sensor 1000 according to another embodiment. Referring to FIGS. 8A and 8B, first to fourth color filters CF1, CF2, CF3, and CF4 of the pixel array 1100b may have the color filter structure shown in FIG. 7B. For example, each of the first to fourth color filters CF1, CF2, CF3 and CF4 may include a resonator including a plurality of nanostructures 124 that are arranged one-dimensionally or two-dimensionally on a plane parallel to a surface of a sensor substrate 110 and an absorption-type filter layer 121 surrounding the nanostructures 124. The absorption-type filter layer 121 may fill a space between the nanostructures 124 and may completely cover lower and upper surfaces of the nanostructures 124. The nanostructures 124 may be differently arranged in the first to fourth color filters CF1, CF2, CF3, and CF4. For example, in the first and fourth color filters CF1 and CF4, the nanostructures 124 may have a first arrangement form to resonate green light in a direction parallel to the surface of the sensor substrate 110. Furthermore, in the second color filter CF2, the nanostructures 124 may have a second arrangement form to resonate blue light in a direction parallel to the surface of the sensor substrate 110, and in the third color filter CF3, the nanostructures 124 may have a third arrangement form to resonate red light in a direction parallel to the surface of the sensor substrate 110.

Although FIGS. 8A and 8B illustrate that the first to fourth color filters CF1, CF2, CF3, and CF4 of the pixel array 1100b have the color filter structure shown in FIG. 7B, the first to fourth color filters CF1, CF2, CF3, and CF4 may have the color filter structure shown in FIG. 7A.

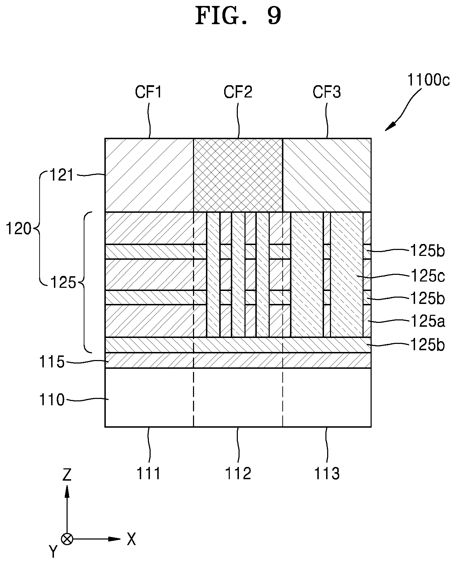

FIG. 9 is a cross-sectional view schematically illustrating a structure of a pixel array 1100c of the image sensor 1000 according to another embodiment. Referring to FIG. 9, the pixel array 1100c may include a sensor substrate 110 and a color filter array 120 disposed on the sensor substrate 110. If necessary, the pixel array 1100c may further include an interlayer insulating film 115 disposed between the sensor substrate 110 and the color filter array 120. The sensor substrate 110 may include a plurality of first to third pixels 111, 112, and 113. The color filter array 120 may include a plurality of first to third color filters CF1, CF2, and CF3 respectively corresponding to the first to third pixels 111, 112, and 113. Each of the first to third color filters CF1, CF2, and CF3 may include an absorption-type filter layer 121 having a polymer-based pigment and a resonant structure 125 configured to absorb or reflect light in a certain wavelength band.

For example, the first pixel 111 may be a cyan pixel, and the first color filter CF1 may be a cyan filter configured to transmit red light and green light and absorb blue light. The second pixel 112 may be a magenta pixel, and the second color filter CF2 may be a magenta filter configured to transmit red and blue light and absorb green light. In addition, the third pixel 113 may be a yellow pixel, and the third color filter CF3 may be a yellow filter configured to transmit green light and blue light and absorb red light. FIG. 9 illustrates that the first to third pixels 111, 112, and 113, and the first to third color filters CF1, CF2, and CF3 are arranged in one row. However, as shown in FIG. 2B, the first and second pixels 111 and 112, and the first and second color filters CF1 and CF2 may be arranged in one row, and the third pixel 113 and the third color filter CF3 may be arranged in another row together with a green pixel and a green filter. In another example, the first pixel 111 may be a green pixel, the first color filter CF1 may be a green filter, the second pixel 112 may be a blue pixel, the second color filter CF2 may be a blue filter, the third pixel 113 may be a red pixel, and the third color filter CF3 may be a red filter.

The resonant structure 125 may be configured to additionally absorb or reflect light in a wavelength band other than a transmission band of the absorption-type filter layer 121 corresponding to the resonant structure 125. For example, the resonant structure 125 may be configured to absorb or reflect light in a wavelength band in which the occurrence of crosstalk is expected. For example, when the first color filter CF1 is a cyan filter, the resonant structure 125 of the first color filter CF1 may be configured to absorb or reflect blue light. When the second color filter CF2 is a magenta filter, the resonant structure 125 of the second color filter CF2 may be configured to absorb or reflect green light. When the third color filter CF3 is a yellow filter, the resonant structure 125 of the third color filter CF3 may be configured to absorb or reflect red light.

To this end, the resonant structures 125 may have a one-dimensional, two-dimensional, or three-dimensional periodic structure. For example, each of the resonant structures 125 may include a plurality of first thin film layers 125a having a first refractive index and a plurality of second thin film layers 125b having a second refractive index different from the first refractive index. The first thin film layers 125a and the second thin film layers 125b may be alternately stacked in a first direction (Z direction). The thickness of each of the first thin film layers 125a and the thickness of each of the second thin film layers 125b may be different from each other or equal to each other. In addition, the resonant structures 125 may further include a plurality of nanorods 125c having a third refractive index different from the first refractive index and the second refractive index. The first thin film layers 125a, the second thin film layers 125b, and the nanorods 125c may include at least one material selected from, for example, Au, Cu, Al, Ag, W, Ti, TiN, SiO2, TiO2, HfO2, Si, and SiN. The nanorods 125c are arranged inside the first thin film layers 125a and the second thin film layers 125b and may extend in the first direction (Z direction). In other words, the nanorods 125c may penetrate each of the first thin film layers 125a and each of the second thin film layers 125b. The nanorods 125c may be arranged in a one-dimensional or two-dimensional periodic form in a second direction (X direction) and/or a third direction (Y direction).

For example, the resonant structure 125 of the first color filter CF1 may include only the first thin film layers 125a and the second thin film layers 125b. The resonant structure 125 of each of the second color filter CF2 and the third color filter CF3 may include the first thin film layers 125a, the second thin film layers 125b, and the nanorods 125c. In the resonant structures 125 of the second color filter CF2 and the third color filter CF3, the nanorods 125c may have different widths and different periods in the second direction (X direction) and/or the third direction (Y direction). However, the configuration of the resonant structures 125 described above are for illustrative purposes only, and according to an intended absorption or reflection wavelength band, the resonant structures 125 may have other configurations different from the configuration described above.

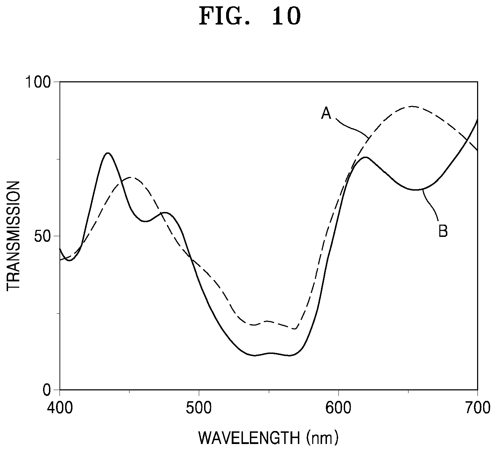

FIG. 10 is a graph illustrating a comparison between a transmission spectrum of a color filter provided according to the embodiment shown in FIG. 9 and a transmission spectrum of a color filter provided according to a comparative example. The color filter of the comparative example is a general magenta filter, and the color filter of the embodiment is a magenta filter having the structure shown in FIG. 9. In the graph shown in FIG. 10, a dashed curve A refers to a transmission spectrum of the color filter of the comparative example, and a solid curve B refers to a transmission spectrum of the color filter of the embodiment. Referring to FIG. 10, it may be seen that when the color filter of the embodiment is used, crosstalk is reduced in a green wavelength band (e.g., 495nm-570 nm) compared to the case of using the color filter of the comparative example. Therefore, when the resonant structures 125 configured to absorb or reflect light in a certain wavelength band are arranged adjacent to the outside of the absorption-type filter layer 121, an undesired wavelength band of light may be additionally absorbed or reflected, and thus crosstalk may be reduced.

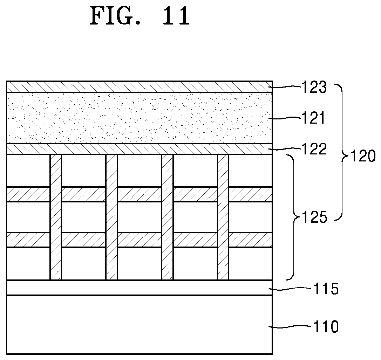

FIG. 11 is a cross-sectional view schematically illustrating a structure of a color filter according to another embodiment. Referring to FIG. 11, the color filter of the current embodiment may further include the resonators shown in FIGS. 3A to 4D. For example, the color filter may include an absorption-type filter layer 121, a first reflective film 122 disposed on a lower surface of the absorption-type filter layer 121, a second reflective film 123 disposed on an upper surface of the absorption-type filter layer 121, and a (grid-shaped) resonant structure 125 disposed between the first reflective film 122 and the sensor substrate 110. Furthermore, in the embodiment shown in FIG. 11, the absorption-type filter layer 121, the first reflective film 122, and the second reflective film 123 may be replaced with the absorption-type filter layer 121 and the resonator shown in FIGS. 7A and 7B.

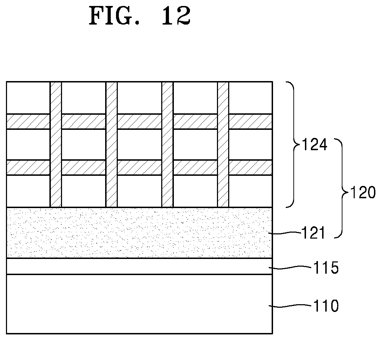

FIG. 12 is a cross-sectional view schematically illustrating a structure of a color filter according to another embodiment. In the embodiment shown in FIG. 9, the resonant structures 125 are disposed between the sensor substrate 110 and the absorption-type filter layers 121. However, the position of the resonant structures 125 are not limited thereto. Referring to FIG. 12, a resonant structure 125 may be disposed on an upper surface of an absorption-type filter layer 121. In other words, the absorption-type filter layer 121 may be disposed between a sensor substrate 110 and the resonant structure 125. In addition, the absorption-type filter layer 121 shown in FIG. 12 may be replaced with the absorption-type filter layer 121, the first reflective film 122, and the second reflective film 123 which are shown in FIGS. 3A to 4D, or may be replaced with the absorption-type filter layer 121 and the resonator shown in FIGS. 7A and 7B.

The image sensor 1000 including the plurality of color filters described above may reduce crosstalk and have a relatively high signal-to-noise ratio even though the image sensor 1000 has a small pixel size. Therefore, it is possible to manufacture an ultra-high-resolution, ultra-small, high-sensitivity image sensor having hundreds of millions of pixels or more pixels. Such ultra-high-resolution, ultra-small, high-sensitivity image sensors may be employed in various high-performance optical apparatuses or electronic apparatuses. Examples of the electronic apparatuses may include smartphones, mobile phones, cellular phones, personal digital assistants (PDAs), laptop computers, personal computers (PCs), various portable devices, home appliances, security cameras, medical cameras, automobiles, Internet of Things (IoT) devices, and mobile or non-mobile computing devices, but are not limited thereto.

In addition to including the image sensor 1000, such an electronic apparatus may further include a processor for controlling the image sensor 1000, for example, an application processor (AP). The electronic apparatus may control a plurality of hardware or software components by driving an operating system or an application program in the processor and may perform various data processing and operations. The processor may further include a graphics processing unit (GPU) and/or an image signal processor (ISP). When the processor includes an ISP, an image (or video) obtained using the image sensor 1000 may be stored and/or output using the processor.

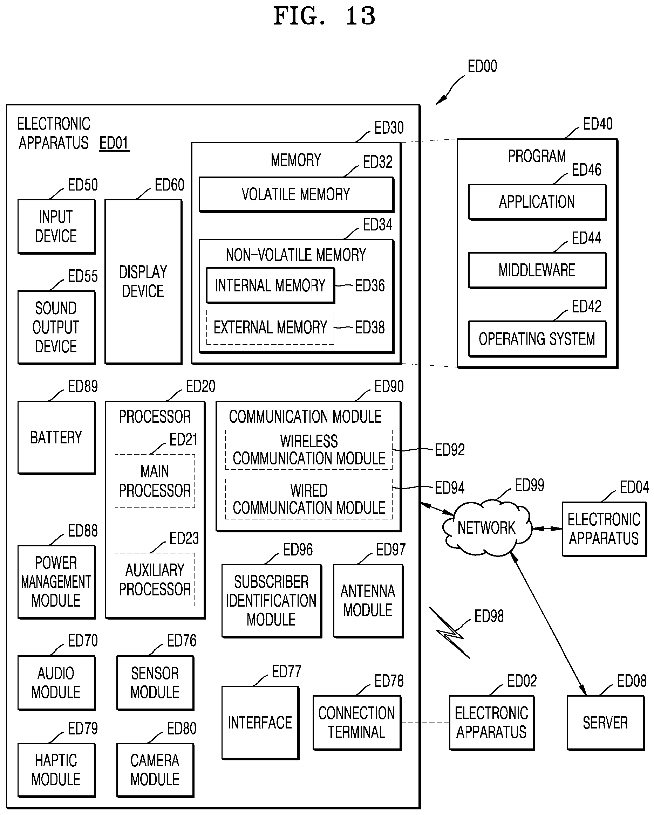

FIG. 13 is a block diagram illustrating, as an example, an electronic apparatus ED01 including the image sensor 1000. Referring to FIG. 13, in a network environment ED00, the electronic apparatus ED01 may communicate with another electronic apparatus ED02 through a first network ED98 (a near-field wireless communication network or the like) or may communicate with another electronic apparatus ED04 and/or a server ED08 through a second network ED99 (a far-field wireless communication network or the like). The electronic apparatus ED01 may communicate with the electronic apparatus ED04 through the server ED08. The electronic apparatus ED01 may include a processor ED20, a memory ED30, an input device ED50, a sound output device ED55, a display device ED60, an audio module ED70, a sensor module ED76, an interface ED77, a haptic module ED79, a camera module ED80, a power management module ED88, a battery ED89, a communication module ED90, a subscriber identification module ED96, and/or an antenna module ED97. Some (the display device ED60, etc.) of the components may be omitted from the electronic apparatus ED01, or other components may be added to the electronic apparatus ED01. Some of the components may be implemented in one integrated circuit. For example, the sensor module ED76 (a fingerprint sensor, an iris sensor, an illuminance sensor, etc.) may be embedded in the display device ED76 (a display or the like).

The processor ED20 may execute software (a program ED40 or the like) to control one or more other components (hardware or software components, etc.) of the electronic apparatus ED01 connected to the processor ED20, and may perform a variety of data processing or operations. As a portion of the data processing or operations, the processor ED20 may load instructions and/or data received from other components (the sensor module ED76, the communication module ED90, etc.) into a volatile memory ED32, process the instructions and/or data stored in the volatile memory ED32, and store result data in a nonvolatile memory ED34. The processor ED20 may include a main processor ED21 (a central processing unit, an application processor, or the like) and an auxiliary processor ED23 (a GPU, an ISP, a sensor hub processor, a communication processor, or the like), which is operated independently or together with the main processor ED21. The auxiliary processor ED23 may consume less power than the main processor ED21 and may perform specialized functions.

The auxiliary processor ED23 may control functions and/or states related to some (the display device ED60, the sensor module ED76, the communication module ED90, etc.) of the components of the electronic apparatus ED01 on behalf of the main processor ED21 while the main processor ED21 is in an inactive (e.g., sleep) state or together with the main processor ED21 while the main processor ED21 is in an active (e.g., application execution) state. The auxiliary processor ED23 (an ISP, a communication processor or the like) may be implemented as a portion of other functionally relevant components (the camera module ED80, the communication module ED90, etc.).

The memory ED30 may store a variety of data required by the components (the processor ED20, the sensor module ED76, etc.) of the electronic apparatus ED01. The data may include, for example, software (the program ED40, etc.) and input data and/or output data for commands related thereto. The memory ED30 may include the volatile memory ED32 and/or the nonvolatile memory ED34. The nonvolatile memory ED34 may include an internal memory ED36 fixed to the electronic apparatus ED01 and an external memory ED38 removable from the electronic apparatus ED01.

The program ED40 may be stored as software in the memory ED30, and may include an operating system ED42, middleware ED44, and/or an application ED46.

The input device ED50 may receive commands and/or data to be used for the components (the processor ED20, etc.) of the electronic apparatus ED01 from the outside (a user, etc.) of the electronic apparatus ED01. The input device ED50 may include a microphone, a mouse, a keyboard, and/or a digital pen (a stylus pen or the like).

The audio output device ED55 may output an audio signal to the outside of the electronic apparatus ED01. The audio output device ED55 may include a speaker and/or a receiver. The speaker may be used for general purposes such as multimedia playback or record playback, and the receiver may be used to receive incoming calls. The receiver may be provided as a portion of the speaker or may be implemented as a separate device.

The display device ED60 may visually provide information to the outside of the electronic apparatus ED01. The display device ED60 may include a display, a hologram device, or a projector, and a control circuit for controlling devices. The display device ED60 may include touch circuitry set to sense a touch, and/or sensor circuitry (a pressure sensor, etc.) configured to measure the intensity of force generated by the touch.

The audio module ED70 may convert sound into an electrical signal, and vice versa. The audio module ED70 may obtain sound through the input device ED50, or may output sound through the audio output device ED55 and/or speakers and/or headphones of another electronic apparatus (the electronic apparatus ED02 or the like) directly or wirelessly connected to the electronic apparatus ED01.

The sensor module ED76 may detect an operating state (power, temperature, etc.) of the electronic apparatus ED01 or an external environmental state (user status, etc.), and may generate an electrical signal and/or a data value corresponding to the detected state. The sensor module ED76 may include a gesture sensor, a gyro sensor, a barometric sensor, a magnetic sensor, an acceleration sensor, a grip sensor, a proximity sensor, a color sensor, an infrared (IR) sensor, a biological sensor, a temperature sensor, a humidity sensor, and/or an illuminance sensor.

The interface ED77 may support one or more designated protocols, which may be used to directly or wirelessly connect the electronic apparatus ED01 with other electronic apparatuses (the electronic apparatus ED02, etc.). The interface ED77 may include a high definition multimedia interface (HDMI), a universal serial bus (USB) interface, a secure digital (SD) card interface, and/or an audio interface.

A connection terminal ED78 may include a connector through which the electronic apparatus ED01 may be physically connected to other electronic apparatuses (the electronic apparatus ED02, etc.). The connection terminal ED78 may include an **HDMI** connector, a USB connector, an SD card connector, and/or an audio connector (a headphone connector, etc.).

The haptic module ED79 may convert an electrical signal into a mechanical stimulus (vibration, movement, etc.) or an electrical stimulus that a user may perceive through tactile sensation or kinesthesia. The haptic module ED79 may include a motor, a piezoelectric element, and/or an electric stimulation device.

The camera module ED80 may capture a still image and a moving image. The camera module ED80 may include a lens assembly including one or more lenses, the image sensor 1000 shown in FIG. 1, ISPs, and/or flashes. The lens assembly included in the camera module ED80 may collect light coming from an object to be imaged.

The power management module ED88 may manage power supplied to the electronic apparatus ED01. The power management module ED88 may be implemented as a portion of a power management integrated circuit PMIC.

The battery ED89 may supply power to components of the electronic apparatus ED01. The battery ED89 may include a non-rechargeable primary battery, a rechargeable secondary battery, and/or a fuel cell.

The communication module ED90 may support establishment of a direct (wired) communication channel and/or a wireless communication channel between the electronic apparatus ED01 and other electronic apparatuses (the electronic apparatus ED02, the electronic apparatus ED04, the server ED08, etc.), and communication through the established communication channel. The communication module ED90 operates independently of the processor ED20 (an application processor, etc.) and may include one or more communication processors supporting direct communication and/or wireless communication. The communication module ED90 may include a wireless communication module ED92 (a cellular communication module, a short-range wireless communication module, a global navigation satellite system (GNSS), or the like) and/or a wired communication module ED94 (a local area network (LAN) communication module, a power line communication module, or the like). A corresponding communication module from among these communication modules may communicate with other electronic apparatuses through the first network ED98 (a local area network such as Bluetooth, WiFi Direct, or infrared data association (IrDA)) or the second network ED99 (a telecommunication network such as a cellular network, the Internet, or computer networks (LAN, WAN, etc.)). These various types of communication modules may be integrated into a single component (a single chip or the like) or may be implemented as a plurality of separate components (multiple chips). The wireless communication module ED92 may identify and authenticate the electronic apparatus ED01 within a communication network such as the first network ED98 and/or the second network ED99 using subscriber information (an international mobile subscriber identifier (IMSI), etc.) stored in the subscriber identity module ED96.

The antenna module ED97 may transmit and/or receive signals and/or power to and/or from the outside (other electronic apparatuses, etc.). An antenna may include a radiator made of a conductive pattern formed on a substrate (a PCB, etc.). The antenna module ED97 may include one or more such antennas. When a plurality of antennas are included in the antenna module ED97, the communication module ED90 may select an antenna suitable for a communication method used in a communication network, such as the first network ED98 and/or the second network ED99, among the plurality of antennas. Signals and/or power may be transmitted or received between the communication module ED90 and other electronic apparatuses through the selected antenna. Other components (an RFIC, etc.) besides the antenna may be included as part of the antenna module ED97.

Some of the components may be connected to each other and exchange signals (commands, data, etc.) through a communication method between peripheral devices (a bus, general purpose input and output (GPIO), a serial peripheral interface (SPI), a mobile industry processor interface (MIPI), or the like).

Commands or data may be transmitted or received between the electronic apparatus ED01 and an external apparatus such as the electronic apparatus ED04 through the server ED08 connected to the second network ED99. The other electronic apparatuses ED02 and ED04 may be the same as or different from the electronic apparatus ED01. All or some of the operations of the electronic apparatus ED01 may be executed by one or more of the other electronic apparatuses ED02, ED04, and ED08. For example, when the electronic apparatus ED01 needs to perform certain functions or services, the electronic apparatus ED01 may request one or more other electronic apparatuses to perform some or all of the functions or services instead of directly executing the functions or services. One or more other electronic apparatuses that have received the request may execute an additional function or service related to the request, and may transfer results of the execution to the electronic apparatus ED01. To this end, cloud computing, distributed computing, and/or client-server computing techniques may be used.

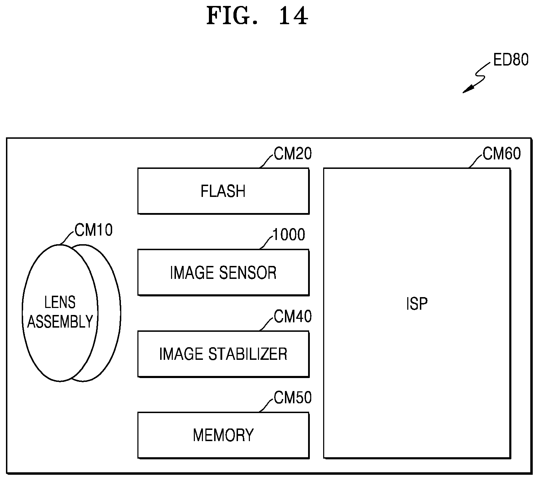

FIG. 14 is a block diagram illustrating an example of the camera module ED80. Referring to FIG. 14, the camera module ED80 may include a lens assembly CM10, a flash CM20, an image sensor 1000 (such as the image sensor 1000 shown in FIG. 1), an image stabilizer CM40, a memory CM50 (a buffer memory, etc.), and/or an ISP CM60. The lens assembly CM10 may collect light coming from an object to be imaged. The camera module ED80 may include a plurality of lens assemblies CM10, and in this case, the camera module ED80 may be a dual camera, a 360-degree camera, or a spherical camera. Some of the plurality of lens assemblies CM10 may have the same lens properties (field of view, focal length, autofocus, F Number, optical zoom, etc.) or different lens properties. Each of the lens assemblies CM10 may include a wide-angle lens or a telephoto lens.

The flash CM20 may emit light used to enhance light emitted or reflected from an object. The flash CM20 may include one or more light emitting diodes (a red-green-blue (RGB) LED, a white LED, an infrared LED, an ultraviolet LED, etc.), and/or a xenon lamp. The image sensor 1000 may be the image sensor 1000 described with reference to FIG. 1 and may obtain an image corresponding to an object by converting light, which is emitted or reflected from the object and transmitted to the image sensor 1000 through the lens assembly CM10, into an electrical signal. The image sensor 1000 may include one or more sensors selected from image sensors having different properties, such as another RGB image sensor, a black and white (BW) sensor, an infrared sensor, or an ultraviolet sensor. Each of the sensors included in the image sensor 1000 may be implemented as a CCD sensor and/or a CMOS sensor.

The image stabilizer CM40 may move one or more lenses included in the lens assembly CM10 or the image sensor 1000 in a specific direction in response to a movement of the camera module ED80 or the electronic apparatus ED01 including the camera module ED80, or may control operational characteristics of the image sensor 1000 (adjustment of read-out timing, etc.) to compensate for negative effects caused by movement. The image stabilizer CM40 may detect a movement of the camera module ED80 or the electronic apparatus ED01 by using a gyro sensor or an acceleration sensor arranged inside or outside the camera module ED80. The image stabilizer CM40 may be an optical image stabilizer.

In the memory CM50, some or all of data obtained through the image sensor 1000 may be stored for the next image processing operation. For example, when a plurality of images are obtained at a high speed, the obtained original data (Bayer-patterned data, high-resolution data, or the like) may be stored in the memory CM50 and only a low-resolution image may be displayed. Then, the original data of a selected image (user selection, etc.) may be transferred to the ISP CM60. The memory CM50 may be integrated into the memory ED30 of the electronic apparatus ED01 or may be configured as a separate memory that may be independently operated.

The ISP CM60 may perform one or more image processes on an image obtained through the image sensor 1000 or image data stored in the memory CM50. The one or more image processes may include depth map generation, three-dimensional modeling, panorama generation, feature point extraction, image synthesis, and/or image compensation (noise reduction, resolution adjustment, brightness adjustment, blurring, sharpening, softening, etc.). The ISP CM60 may control (exposure time control, read-out timing control, etc.) components (the image sensor 1000, etc.) included in the camera module CM80. An image processed by the ISP CM60 may be stored again in the memory CM50 for additional processing or may be provided to external components (the memory ED30, the display device ED60, the electronic apparatus ED02, the electronic apparatus ED04, the server ED08, etc.) of the camera module ED80. The ISP CM60 may be integrated into the processor ED20 or may be configured as a separate processor that operates independently of the processor ED20. When the ISP CM60 is provided separately from the processor ED20, an image processed by the ISP CM60 may be displayed on the display device ED60 after being further processed by the processor ED20.

The electronic apparatus ED01 may include a plurality of camera modules ED80 having different attributes or functions. In this case, one of the plurality of camera modules ED80 may be a wide-angle camera, and another of the plurality of camera modules ED80 may be a telephoto camera. Similarly, one of the plurality of camera modules ED80 may be a front camera, and another of the plurality of camera modules ED80 may be a rear camera.

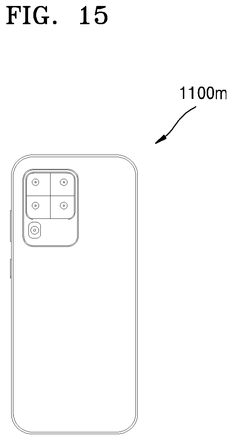

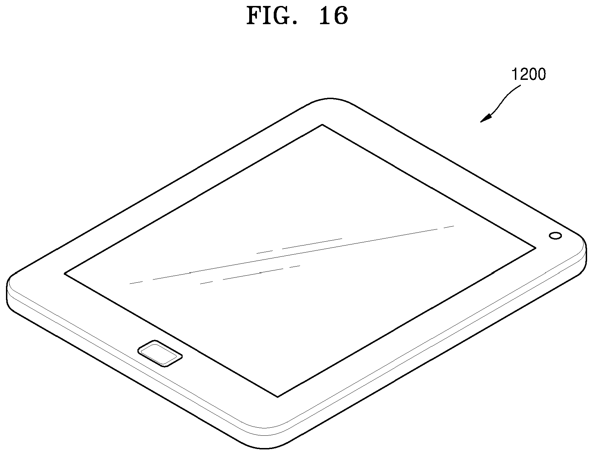

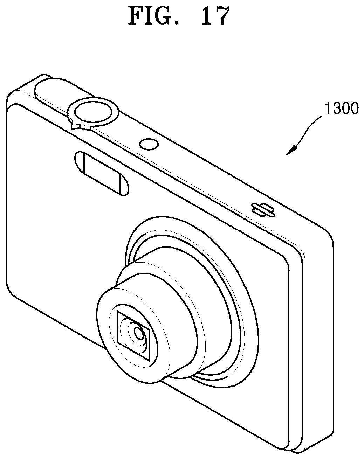

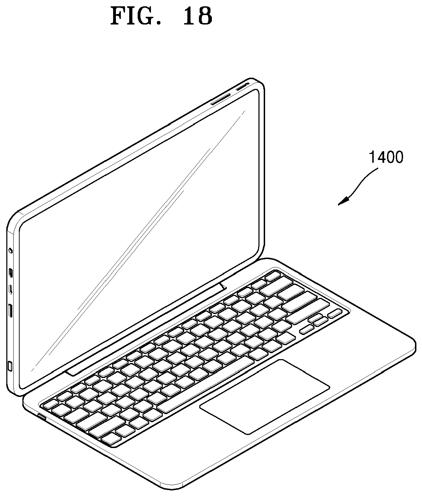

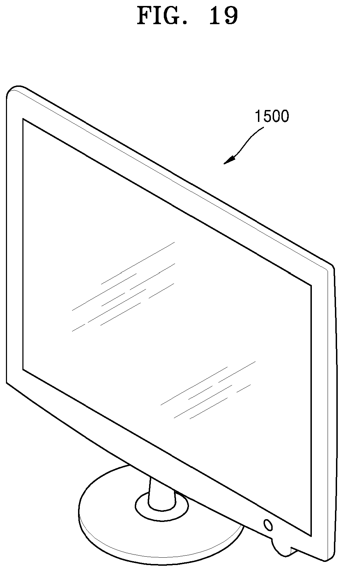

According to embodiments, the image sensor 1000 may be applied to a mobile phone or smartphone 1100m shown in FIG. 15, a tablet or smart tablet 1200 shown in FIG. 16, a digital camera or camcorder 1300 shown in FIG. 17, a laptop computer 1400 shown in FIG. 18, or a television or smart television 1500 shown in FIG. 19. For example, the smartphone 1100m or the smart tablet 1200 may include a plurality of high-resolution cameras each having a high-resolution image sensor mounted thereon. The high-resolution cameras may be used to extract depth information of objects in an image, adjust out of focus of an image, or automatically identify objects in an image.

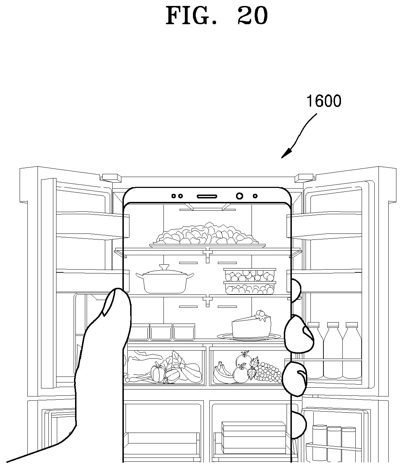

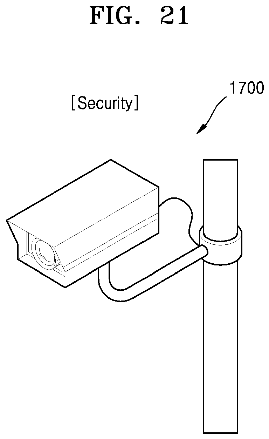

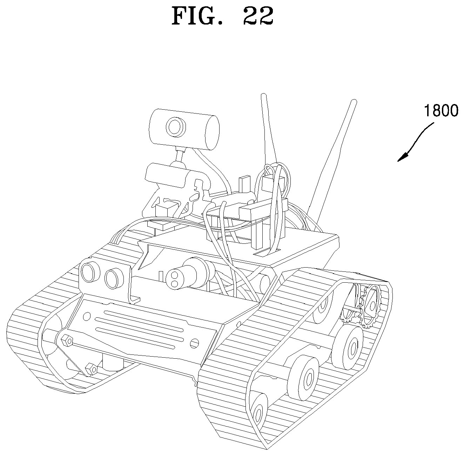

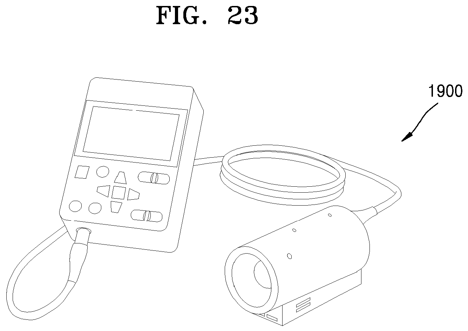

In addition, the image sensor 1000 may be applied to a smart refrigerator 1600 shown in FIG. 20, a security camera 1700 shown in FIG. 21, a robot 1800 shown in FIG. 22, a medical camera 1900 shown in FIG. 23, and the like. For example, the smart refrigerator 1600 may automatically recognize food contained in the smart refrigerator 1600 by using the image sensor 1000, and may inform a user of whether a specific food is contained in the smart refrigerator 1600, the type of food put into or out of the smart refrigerator 1600, and the like through a smartphone. The security camera 1700 may provide an ultra-high-resolution image and may recognize an object or a person in the ultra-high-resolution image even in a dark environment owing to high sensitivity of the security camera 1700. The robot 1800 may be sent to a disaster or industrial site that cannot be directly accessed by humans and may provide high-resolution images. The medical camera 1900 may provide a high-resolution image for diagnosis or surgery, and may have a dynamically adjustable field of view.

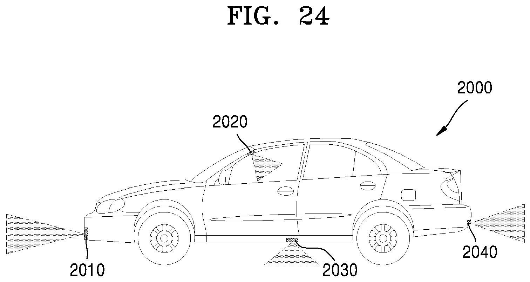

In addition, the image sensor 1000 may be applied to a vehicle 2000 as shown in FIG. 24. The vehicle 2000 may include a plurality of vehicle cameras 2010, 2020, 2030, and 2040 arranged at various positions. Each of the vehicle cameras 2010, 2020, 2030, and 2040 may include an image sensor according to an embodiment. The vehicle 2000 may use the vehicle cameras 2010, 2020, 2030, and 2040 to provide a driver with various information about the interior or surroundings of the vehicle 2000, and may provide information necessary for autonomous driving by automatically recognizing objects or people in images.

While image sensors and electronic apparatuses including the image sensors have been described according to embodiments with reference to the accompanying drawings, it will be understood by those of ordinary skill in the art that the opto-electronic devices and the image sensors are merely examples, and various modifications and other equivalent embodiments may be made therein. Therefore, the embodiments described herein should be considered in a descriptive sense only and not for purposes of limitation. The scope of the disclosure is defined not by the above description but by the following claims.

## Claims

1. An image sensor (1000) comprising:
a sensor substrate (110) comprising a plurality of first pixels (111) and a plurality of second pixels (112); and
a color filter array (120) comprising a plurality of first color filters (CF1) respectively corresponding to the plurality of first pixels (111) and a plurality of second color filters (CF2) respectively corresponding to the plurality of second pixels (112),
wherein each of the plurality of first color filters (CF1) and the plurality of second color filters (CF2) comprises:
an absorption-type filter layer (121) comprising a polymer-based pigment according to the wavelength of light to be transmitted; and
a resonator comprising a first reflective film (122) and a second reflective film (123) provided on two opposing surfaces of the absorption-type filter layer (121), respectively, to allow light to resonate in the absorption-type filter layer (121).

2. The image sensor of claim 1, wherein the first reflective film is provided on a lower surface of the absorption-type filter layer and the second reflective film is provided on an upper surface of the absorption-type filter layer, and
wherein the lower surface and the upper surface of the absorption-type filter layer oppose each other.

3. The image sensor of claim 1 or 2, wherein the absorption-type filter layer of each the plurality of first color filters comprises a first pigment configured to transmit light in a first wavelength band and absorbs light in other wavelength bands, and the absorption-type filter layer of each of the plurality of second color filters comprises a second pigment configured to transmit light in a second wavelength band different from the first wavelength band and absorbs light in other wavelength bands.

4. The image sensor of one of claims 1 to 3, wherein the resonator has one of a range of a quality factor, Q-factor:
a range of the Q-factor of 1.5 to 20,
a range of the Q-factor of 2 to 10, and
a range of a Q-factor of 2 to 5.

5. The image sensor of one of claims 1 to 4, wherein the resonator has a Fabry-Perot resonant structure in which the absorption-type filter layer is disposed inside the resonator.

6. The image sensor of one of claims 1 to 5, wherein an arithmetic sum of a reflectance of the first reflective film and a reflectance of the second reflective film is 50 % to 150 %, and
wherein the reflectance of the first reflective film and the reflectance of the second reflective film are set such that a transmission spectrum of each of the plurality of first color filters and the plurality of second color filters has a full width at half maximum within a range of 50 nm to 250 nm.

7. The image sensor of one of claims 1 to 6, wherein each of the first reflective film and the second reflective film has a one-dimensional periodic structure in which periodic structures are arranged in one direction, or two-dimensional periodic structure in which the periodic structures are arranged in two directions.

8. The image sensor of one of claims 1 to 6, wherein each of the first reflective film and the second reflective film comprise a distributed Bragg reflector.

9. The image sensor of one of claims 1 to 6, wherein each of the first reflective film and the second reflective film comprise at least one metal or metalloid material selected from polysilicon ,poly-Si, gold, Au, copper, Cu, aluminum, Al, silver, Ag, tungsten, W, and titanium, Ti.

10. The image sensor of claim 9, wherein each of the first reflective film and the second reflective film has a thickness of 1 nm to 30 nm.

11. The image sensor of one of claims 1 to 6, wherein the first reflective film and the second reflective film comprise at least one dielectric material selected from poly-Si, TiN, SiO₂, TiO₂, HfO₂, Ta₂O₅, SiC, and SiN, and
wherein each of the first reflective film and the second reflective film has a thickness of 30 nm to 600 nm.

12. The image sensor of one of claims 1 to 6, wherein the absorption-type filter layer of each of the plurality of first color filters has a thickness equal to a thickness of the absorption-type filter layer of each of the plurality of second color filters, and
wherein in the plurality of first color filters and the plurality of second color filters, the first reflective films cause different phase delays, or the second reflective films cause different phase delays.

13. The image sensor of one of claims 1 to 6, wherein the absorption-type filter layer of each of the plurality of first color filters has a first thickness, and the absorption-type filter layer of each of the plurality of second color filters has a second thickness different from the first thickness.

14. The image sensor of claim 13, wherein the first thickness of the absorption-type filter layer of each of the plurality of first color filters is set such that a center wavelength of a transmission wavelength band of each of the plurality of first color filters is equal to a resonant wavelength of the resonator of each of the plurality of first color filters, and the second thickness of the absorption-type filter layer of each of the plurality of second color filters is set such that a center wavelength of a transmission wavelength band of each of the plurality of second color filters is equal to a resonant wavelength of the resonator of each of the plurality of second color filters.

15. An electronic apparatus comprising:
an image sensor according to one of claims 1 to 14 configured to convert an optical image into an electrical signal; and
a processor configured to control the image sensor.

## Patentansprüche

1. Bildsensor (1000), umfassend:
ein Sensorsubstrat (110), das eine Vielzahl von ersten Pixeln (111) und eine Vielzahl von zweiten Pixeln (112) umfasst, und
ein Farbfilterarray (120), das eine Vielzahl von ersten Farbfiltern (CF1), die jeweils der Vielzahl von ersten Pixeln (111) entsprechen, und eine Vielzahl von zweiten Farbfiltern (CF2), die jeweils der Vielzahl von zweiten Pixeln (112) entsprechen, umfasst,
wobei jeder der Vielzahl von ersten Farbfiltern (CF1) und der Vielzahl von zweiten Farbfiltern (CF2) umfasst:
eine Filterschicht vom Absorptionstyp (121), die ein Pigment auf Polymerbasis gemäß der Wellenlänge des weiterzuleitenden Lichts umfasst; und
einen Resonator, der eine erste reflektierende Schicht (122) und eine zweite reflektierende Schicht (123) umfasst, welche jeweils auf zwei einander gegenüberliegenden Oberflächen der Filterschicht vom Absorptionstyp (121) vorgesehen sind, um Licht in der Filterschicht vom Absorptionstyp (121) in Resonanz treten zu lassen.

2. Bildsensor nach Anspruch 1, wobei die erste reflektierende Schicht auf einer Unterseite der Filterschicht vom Absorptionstyp und die zweite reflektierende Schicht auf einer Oberseite der Filterschicht vom Absorptionstyp vorgesehen ist und
wobei die Unterseite und die Oberseite der Filterschicht vom Absorptionstyp einander gegenüberliegen.

3. Bildsensor nach Anspruch 1 oder 2, wobei die Filterschicht vom Absorptionstyp jedes der Vielzahl von ersten Farbfiltern ein erstes Pigment umfasst, welches so ausgelegt ist, dass es Licht in einem ersten Wellenlängenband weiterleitet und Licht in anderen Wellenlängenbändern absorbiert, und die Filterschicht vom Absorptionstyp jedes der Vielzahl von zweiten Farbfiltern ein zweites Pigment umfasst, welches so ausgelegt ist, dass es Licht in einem zweiten Wellenlängenband, das sich vom ersten Wellenlängenband unterscheidet, weiterleitet und Licht in anderen Wellenlängenbändern absorbiert.

4. Bildsensor nach einem der Ansprüche 1 bis 3, wobei der Resonator einen aus einem Bereich eines Qualitätsfaktors, Q-Faktor, aufweist:
einen Bereich des Q-Faktors von 1,5 bis 20,
einen Bereich des Q-Faktors von 2 bis 10 und
einen Bereich des Q-Faktors von 2 bis 5.

5. Bildsensor nach einem der Ansprüche 1 bis 4, wobei der Resonator eine Fabry-Perot-Resonanzstruktur aufweist, bei welcher die Filterschicht vom Absorptionstyp innerhalb des Resonators angeordnet ist.

6. Bildsensor nach einem der Ansprüche 1 bis 5, wobei eine arithmetische Summe aus dem Reflexionsgrad der ersten reflektierenden Schicht und dem Reflexionsgrad der zweiten reflektierenden Schicht 50 % bis 150 % beträgt und
wobei das Reflexionsvermögen der ersten reflektierenden Schicht und das Reflexionsvermögen der zweiten reflektierenden Schicht so eingestellt sind, dass ein Transmissionsspektrum jedes der Vielzahl von ersten Farbfiltern und der Vielzahl von zweiten Farbfiltern eine Halbwertsbreite innerhalb eines Bereichs von 50 nm bis 250 nm aufweist.

7. Bildsensor nach einem der Ansprüche 1 bis 6, wobei jede der ersten reflektierenden Schicht und der zweiten reflektierenden Schicht eine eindimensionale periodische Struktur, bei der periodische Strukturen in einer Richtung angeordnet sind, oder eine zweidimensionale periodische Struktur, bei der die periodischen Strukturen in zwei Richtungen angeordnet sind, aufweist.

8. Bildsensor nach einem der Ansprüche 1 bis 6, wobei jede der ersten reflektierenden Schicht und der zweiten reflektierenden Schicht einen verteilten Bragg-Reflektor umfasst.

9. Bildsensor nach einem der Ansprüche 1 bis 6, wobei jede der ersten reflektierenden Schicht und der zweiten reflektierenden Schicht mindestens ein Metall- oder Metalloid-Material umfassen, das aus Polysilizium (Poly-Si), Gold (Au), Kupfer (Cu), Aluminium (Al), Silber (Ag), Wolfram (W) und Titan (Ti) ausgewählt ist.

10. Bildsensor nach Anspruch 9, wobei jede der ersten reflektierenden Schicht und der zweiten reflektierenden Schicht eine Dicke von 1 nm bis 30 nm aufweist.

11. Bildsensor nach einem der Ansprüche 1 bis 6, wobei die erste reflektierende Schicht und die zweite reflektierende Schicht mindestens ein dielektrisches Material umfassen, welches aus Poly-Si, TiN, SiO₂, TiO₂, HfO₂, Ta₂O₅, SiC und SiN ausgewählt ist, und
wobei jede der ersten reflektierenden Schicht und der zweiten reflektierenden Schicht eine Dicke von 30 nm bis 600 nm aufweist.

12. Bildsensor nach einem der Ansprüche 1 bis 6, wobei die Filterschicht vom Absorptionstyp jedes der Vielzahl von ersten Farbfiltern eine Dicke aufweist, die gleich einer Dicke der Filterschicht vom Absorptionstyp jedes der Vielzahl von zweiten Farbfiltern ist, und
wobei in der Vielzahl von ersten Farbfiltern und der Vielzahl von zweiten Farbfiltern die ersten reflektierenden Schichten unterschiedliche Phasenverzögerungen bewirken oder die zweiten reflektierenden Schichten unterschiedliche Phasenverzögerungen bewirken.

13. Bildsensor nach einem der Ansprüche 1 bis 6, wobei die Filterschicht vom Absorptionstyp jedes der Vielzahl von ersten Farbfiltern eine erste Dicke aufweist und die Filterschicht vom Absorptionstyp jedes der Vielzahl von zweiten Farbfiltern eine zweite Dicke aufweist, welche sich von der ersten Dicke unterscheidet.

14. Bildsensor nach Anspruch 13, wobei die erste Dicke der Filterschicht vom Absorptionstyp jedes der Vielzahl von ersten Farbfiltern so eingestellt ist, dass eine Mittenwellenlänge eines Übertragungswellenlängenbandes jedes der Vielzahl von ersten Farbfiltern gleich einer Resonanzwellenlänge des Resonators jedes der Vielzahl von ersten Farbfiltern ist, und die zweite Dicke der Filterschicht vom Absorptionstyp jedes der Vielzahl von zweiten Farbfiltern so eingestellt ist, dass eine Mittenwellenlänge eines Übertragungswellenlängenbandes jedes der Vielzahl von zweiten Farbfiltern gleich einer Resonanzwellenlänge des Resonators jedes der Vielzahl von zweiten Farbfiltern ist.

15. Elektronisches Gerät, umfassend:
einen Bildsensor gemäß einem der Ansprüche 1 bis 14, welcher dazu konfiguriert ist, ein optisches Bild in ein elektrisches Signal umzuwandeln; und
einen Prozessor, der dazu konfiguriert ist, den Bildsensor zu steuern.

## Revendications

1. Capteur d'image (1000) comprenant :
un substrat de capteur (110) comprenant une pluralité de premiers pixels (111) et une pluralité de deuxièmes pixels (112) ; et
un réseau de filtres de couleur (120) comprenant une pluralité de premiers filtres de couleur (CF1) correspondant respectivement à la pluralité de premiers pixels (111) et une pluralité de deuxièmes filtres de couleur (CF2) correspondant respectivement à la pluralité de deuxièmes pixels (112),
dans lequel chacun de la pluralité de premiers filtres de couleur (CF1) et chacun de la pluralité de deuxièmes filtres de couleur (CF2) comprennent :
une couche de filtre de type absorption (121) comprenant un pigment à base de polymère adapté à la longueur d'onde de la lumière à transmettre ; et
un résonateur comprenant un premier film réfléchissant (122) et un deuxième film réfléchissant (123) prévus respectivement sur deux surfaces opposées de la couche de filtre de type absorption (121), pour permettre à la lumière de résonner dans la couche de filtre de type absorption (121).

2. Capteur d'image selon la revendication 1, dans lequel le premier film réfléchissant est prévu sur une surface inférieure de la couche de filtre de type absorption et le deuxième film réfléchissant est prévu sur une surface supérieure de la couche de filtre de type absorption, et
dans lequel la surface inférieure et la surface supérieure de la couche de filtre de type absorption se font face.

3. Capteur d'image selon la revendication 1 ou 2, dans lequel la couche de filtre de type absorption de chacun de la pluralité des premiers filtres de couleur comprend un premier pigment configuré pour transmettre la lumière dans une première bande de longueurs d'onde et absorber la lumière dans d'autres bandes de longueurs d'onde, et la couche de filtre de type absorption de chacun de la pluralité des deuxièmes filtres de couleur comprend un deuxième pigment configuré pour transmettre la lumière dans une deuxième bande de longueurs d'onde différente de la première bande de longueurs d'onde et pour absorber la lumière dans d'autres bandes de longueurs d'onde.

4. Capteur d'image selon l'une des revendications 1 à 3, dans lequel le résonateur présente l'une des plages suivantes pour le facteur de qualité (Q) :
une plage de facteur Q comprise entre 1,5 et 20,
une plage de facteur Q comprise entre 2 et 10, et
une plage de facteur Q comprise entre 2 et 5.

5. Capteur d'image selon l'une des revendications 1 à 4, dans lequel le résonateur présente une structure résonnante de type Fabry-Pérot dans laquelle la couche de filtre de type absorption est disposée à l'intérieur du résonateur.

6. Capteur d'image selon l'une des revendications 1 à 5, dans lequel la somme arithmétique du pouvoir réfléchissant du premier film réfléchissant et du pouvoir réfléchissant du deuxième film réfléchissant est comprise entre 50 % et 150 %, et dans lequel le pouvoir réfléchissant du premier film réfléchissant et le pouvoir réfléchissant du deuxième film réfléchissant sont réglés de telle sorte que le spectre de transmission de chacun de la pluralité des premiers filtres de couleur et de de la pluralité des deuxièmes filtres de couleur présente une largeur à mi-hauteur comprise dans une plage de 50 nm à 250 nm.

7. Capteur d'image selon l'une des revendications 1 à 6, dans lequel chacun des premier film réfléchissant et deuxième film réfléchissant ont une structure périodique unidimensionnelle dans laquelle les structures périodiques sont agencées dans une seule direction, ou une structure périodique bidimensionnelle dans laquelle les structures périodiques sont agencées dans deux directions.

8. Capteur d'image selon l'une des revendications 1 à 6, dans lequel chacun du premier film réfléchissant et du deuxième film réfléchissant comprennent un réflecteur de Bragg distribué.

9. Capteur d'image selon l'une des revendications 1 à 6, dans lequel le premier film réfléchissant et le deuxième film réfléchissant comprennent chacun au moins un matériau métallique ou métalloïde sélectionné parmi le polysilicium, le poly-Si, l'or, Au, le cuivre, Cu, l'aluminium, Al, l'argent, Ag, le tungstène, W, et le titane, Ti.

10. Capteur d'image selon la revendication 9, dans lequel chacun du premier film réfléchissant et du deuxième film réfléchissant ont une épaisseur comprise entre 1 nm et 30 nm.

11. Capteur d'image selon l'une des revendications 1 à 6, dans lequel le premier film réfléchissant et le deuxième film réfléchissant comprennent au moins un matériau diélectrique sélectionné parmi le poly-Si, le TiN, le SiO₂, le TiO₂, le HfO₂, le Ta₂O₅, SiC et SiN, et
dans lequel chacun du premier film réfléchissant et du deuxième film réfléchissant ont une épaisseur comprise entre 30 nm et 600 nm.

12. Capteur d'image selon l'une des revendications 1 à 6, dans lequel la couche de filtre de type absorption de chacun de la pluralité des premiers filtres de couleur a une épaisseur égale à celle de la couche de filtre de type absorption de chacun de la pluralité des deuxièmes filtres de couleur, et
dans lequel, parmi la pluralité de premiers filtres de couleur et la pluralité de deuxièmes filtres de couleur, les premiers films réfléchissants provoquent des retards de phase différents, ou les deuxièmes films réfléchissants provoquent des retards de phase différents.

13. Capteur d'image selon l'une des revendications 1 à 6, dans lequel la couche de filtre de type absorption de chacun de la pluralité des premiers filtres de couleur a une première épaisseur, et la couche de filtre de type absorption de chacun de la pluralité des deuxièmes filtres de couleur a une deuxième épaisseur différente de la première épaisseur.

14. Capteur d'image selon la revendication 13, dans lequel la première épaisseur de la couche de filtre de type absorption de chacun de la pluralité des premiers filtres de couleur est définie de telle sorte qu'une longueur d'onde centrale d'une bande de longueurs d'onde de transmission de chacun de la pluralité des premiers filtres de couleur soit égale à une longueur d'onde de résonance du résonateur de chacun de la pluralité des premiers filtres de couleur, et la deuxième épaisseur de la couche de filtre de type absorption de chacun de la pluralité des deuxièmes filtres de couleur est définie de telle sorte que la longueur d'onde centrale d'une bande de longueurs d'onde de transmission de chacun de la pluralité des deuxièmes filtres de couleur soit égale à une longueur d'onde de résonance du résonateur de chacun de la pluralité des deuxièmes filtres de couleur.

15. Appareil électronique comprenant :
un capteur d'image selon l'une des revendications 1 à 14, configuré pour convertir une image optique en un signal électrique ; et
un processeur configuré pour commander le capteur d'image.
